(19) Europäisches Patentamt / European Patent Office / Office européen des brevets

(11) **EP 2 003 526 A1**

(12) **EUROPEAN PATENT APPLICATION**

(43) Date of publication:
**17.12.2008 Bulletin 2008/51**

(51) Int Cl.:
**G05B 19/404** [(2006.01)]   **H01J 37/00** [(2006.01)]

(21) Application number: **07011573.8**

(22) Date of filing: **13.06.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Carl Zeiss SMT Limited**
**Cambridge**
**CB1 3JS (GB)**

(72) Inventor: **Cooper, Patrick Milton**
**Cambridge CB4 6XJ (GB)**

(74) Representative: **Tongbhoyai, Martin**
**Patentanwälte Freischem**
**An Gross St. Martin 2**
**50667 Köln (DE)**

(54) **Method and device for controlling and monitoring a position of a holding element**

(57)     The invention refers to a method and a device for controlling and monitoring a position of a holding element which is provided to hold a sample to be examined, in particular by a beam device such as an electron microscope. It is an object of the invention to provide a method and a device for controlling and monitoring a position of a holding element taking any errors with respect to irregularities into account. The invention is based on the idea of interpolation of possible errors.

Fig. 1

**EP 2 003 526 A1**

**Description**

The invention refers to a method and a device for controlling and monitoring a position of a holding element (controlling a positioning of a holding element) which is provided to hold a sample to be examined, in particular by a beam device such as an electron microscope. In particular in a beam device, the holding element is also known as a stage for a sample to be examined.

In devices such as optical microscopes or electron microscopes, it is often necessary to accurately identify points of interest on a sample which is to be examined by a user with the device. It is also desirable to record information about points of interest on such a sample so that the points of interest can be reviewed. In some applications, a first device (for example an optical microscope) is used to identify points of interest such as defects on a sample which are then to be examined in detail with a second device such as an electron microscope. Since those defects are rather small, their location must be recorded with high accuracy to be able to find those defects again and to identify them correctly when they are examined. High accuracy could be achieved with a holding element which can be moved very precisely or can be controlled very precisely, for example by laser interferometry. However, the aforementioned solutions for achieving high accuracy are rather expensive.

It is known that each device has its own coordinate system, in particular due to manufacturing reasons. Therefore, when taking a sample to be examined from a first device with a first coordinate system to a second device with a second coordinate system, it is necessary to translate the coordinates of the sample of the first coordinate system into coordinates of the second coordinate system. This can be done by establishing the location of three points of the sample in both coordinate systems and by calculating the effects of translation, shear, rotation and scaling. However, this translation requires the assumption that coordinates of both coordinate systems consist of straight lines and is, therefore, a linear translation. This assumption is, in reality, not very accurate as mentioned below.

In reality, the coordinate systems for movable parts which hold a sample to be examined (e.g. a motorized holding element of an electron microscope) deviate, albeit only slightly, from this assumption. There exist errors which have to be taken into account. One of these errors is based on mechanical and/or design irregularities of the holding element or the movable parts of the holding element. This error can cause false absolute positioning of the holding element. Another of the errors is based on the weight of the sample which could cause such a physical loading of the holding element that the holding element could move or bend by small amounts, thus changing the exact position of a sample mounted on the holding element under, for example, an electron beam. Additionally, magnetic properties of the sample might influence the position of the holding element. Therefore, a desired position set by a user often does not correspond to a current position which was taken by the holding element after setting the desired position. In other words, when a position comprising a coordinate X and a coordinate Y is desired or reported to a user, the current position of a holding element is in fact X+eX and Y+eY, respectively, where eX and eY are small errors.

These errors also have to be taken into account when a sample is only examined with a single device having a holding element for that sample, since the coordinate system of the holding element is different from the coordinate system which is used by a user to identify points of interest.

Some methods and systems for positioning a holding element known in the art consider the above mentioned errors. For example, a method and a system is known for positioning a driven part of a numerically controlled device and for overcoming, in such positioning, repeatable errors due to mechanical limitations. A memory device forming part of a computer associated with the system is filled with a table of error correction values corresponding to different reference points or areas in the field of movement of the driven part, and as the part is moved to such points or areas, corrections are made in accordance with the table of error correction values. In more detail, by driving the driven part through a grid of positions spread over the entire area of a reference member, error values may be obtained on a two axis basis, with an X error value and a Y error value associated with each reference point. From this, the aforementioned error table is set up which actually represents a family of correction curves, the error values associated with each reference point dependent on, or a function of, the position of the driven part along both of its axes of movement. The computer may be programmed to interpolate the error correction required for any position of the driven part from the error values associated with adjacent reference points and to make error corrections in accordance with such interpolated values as the driven part is moved between reference points.

Another known system is designed as a particle beam device comprising a standard substrate formed with a chip-shaped first mark group having a plurality of first marks and a chip-shaped second mark group having a plurality of second marks, a correction map having misalignment factors of the first marks based on the position of the second marks, and a deflection control unit for controlling an amount of deflection in a deflector for the particle beam. The particle beam is irradiated on a sample while the deflection control unit refers to the correction map and corrects the amount of deflection as equivalent to the misalignment factors.

A further known method includes a detection step of placing a calibration substrate having a plurality of marks on a stage (holding element) and detecting positions of the plurality of marks by a first position detection section using a particle beam and by a second position detection section using light while adjusting a position of the stage. Furthermore, the method includes a correction step of correcting a position where the particle beam is incident on the substrate on which a pattern is to be drawn, in accordance with the position of the stage on the basis of the difference between detection results by the particle beam and the light in the detection step.

US 3,555,254, US 2005/0211929 A1 and US 6,864,488 B2 are prior art.

However, the above mentioned prior art does not take into account a bending of the reference member (reference object), the sample or the holding element. Therefore, the physical loading of a holding element or any other irregularity causing a bending of the holding element automatically leads to further errors. Moreover, the prior art provides corrected coordinates to drive a holding element to the correct physical position which corresponds to a desired position of a user. The desired position is determined in the coordinate system of the user, whereas the correct physical position is determined in the coordinate system of the holding element. However, this correct physical position then reported to the user is not identical to the desired position due to the different coordinate systems. This might confuse the user. Furthermore, the user might position the holding element without entering a desired position in a control device, for example via a mechanical and/or electronic device (for example a joystick). After having positioned the holding element, the position should be reported to the user. However, as mentioned above, the prior art reports the physical position taken by the holding element in the coordinate system of the holding element or the beam device instead of the position in the user's coordinate system. This leads automatically to errors in further processing the sample since the user would not be able to return to the position he actually has chosen before. This occurs because the holding element will not be moved to this reported physical position when entering the reported physical position given in the coordinates of the coordinate system of the holding element or the beam device as a desired position. Rather, it will be moved to a further physical position due to the errors mentioned above.

Therefore, it is an object of the invention to provide a method and a device for controlling and/or monitoring a position of a holding element which consider errors and provide accurate positioning and monitoring of a holding element.

This object is achieved by a method with the features of claim 1. A device according to the invention is given by the features of claims 22 and 30, respectively.

The invention is based on the following basic idea. A hypothetical solution for avoiding any error would be to create a table which would record errors of any possible position X, Y with their corresponding errors eX and eY (eX and eY are errors at position X, Y). When a user requests a physical position (X', Y'), one could simply search the table for the location where X+eX most closely matches X' and Y+eY most closely matches Y'. To do a reverse translation when a device reports the position X, Y, one could simply look at the table and report X+eX and Y+eY to tell the user the actual physical position X', Y'. Obviously, creating such a table is not economically feasible since recording every addressable point on any sort of holding element would require enormous computational storage.

Therefore, the invention is based on the idea of determining exact positions of some reference points and the errors at those reference points. Considering those reference points and those errors, the errors at each possible location (point of interest) are determined. To create such a determination, it is useful to consider the translation of the position X, Y to eX and X, Y to eY as a pair of surfaces. X and Y are the x-coordinate and y-coordinate, respectively, of a Cartesian coordinate system, whereas the errors eX and eY are the "heights" of the surfaces and are, therefore, the z-coordinate of the Cartesian coordinate system. If the reference points are placed as dots in two three dimensional spaces (one space for (X,Y,eX) and the other space for (X,Y, eY)), each surface (one for eX and one for eY) can be created by "filling in" each point between the reference points. This "filling in" may be carried out by (but is not limited to) interpolation, as explained further below.

The invention needs a reference object which might be a reference object separate from the sample to be examined or which can be designed as the sample itself. The reference object provides at least one first position as a reference point.

The method according to the invention is based on providing a non-linear transformation between two coordinate systems, in particular between the coordinate system of a user and a coordinate system of a device or between the coordinate systems of two different devices. The non-linear transformation is necessary due to the effects mentioned above and is carried out in both directions, e.g. from the coordinate system of a device into a coordinate system of a user and vice versa. The coordinate system of a user can typically be the coordinates of the surface of a sample, whereas the coordinate system of the device is the coordinate system of the holding element which is given for example by the drive system of the holding element. In particular, a user is often interested in some areas on a sample in relation to each other. It should be noted that the invention is not limited to user coordinate systems with a physical existence, but may also be useful with any non linear abstract user defined coordinate systems.

The method according to the invention controls and monitors a position of a holding element, the holding element being provided to hold a sample to be examined and being part of a device. Furthermore, the holding element takes a physical position in a first coordinate system when being in a corresponding position in a second coordinate system. The second coordinate system is, for example, the coordinate system of the user. The method comprises the following steps. At least one first position in the second coordinate system is provided as a reference point (calibration). The first position is provided by a reference object. The holding element takes a first physical position in said first coordinate system in said first position. The first position can be any arbitrary or well known position. Furthermore, it is assumed that the first position has a first position error ("zero error"). This will be explained in detail further below. The method also comprises the step of providing at least one error map which is based on the first position. The error map comprises a deviation of at least one second physical position of the holding element in the first coordinate system from a corresponding position of the holding element in the second coordinate system. In other words, the error map provides deviations for some physical positions of the holding element in the first coordinate system from their corresponding position of the holding element in the second coordinate system. Moreover, the method comprises the step of providing at least one correction map based on the error map. The correction map comprises a deviation of at least one third physical position of the holding element in the first coordinate system from a corresponding position of the holding element in the second coordinate system. It provides the possibility to find the correct position for each and every position in each coordinate system. The correction map provides a non-linear coordinate translation between the first coordinate system and the second coordinate system. Moreover, the method further comprises at least one of the steps of: moving the holding element to the third physical position in the first coordinate system corresponding to the position as a desired position in the second coordinate system according to the correction map; and reporting the position in the second coordinate system corresponding to the third physical position in the first coordinate system by means of the correction map.

An advantage of the method mentioned above is that a transformation taking into account the effects mentioned above, in particular mechanical irregularities of the holding element or bending due to the weight of a sample, provides transformation between two coordinate systems and is accurately carried out in both directions, e.g. from the coordinate system of a device into a coordinate system of a user and vice versa. Therefore, the method provides moving the holding element to a correct physical position when a user requires the holding element to be at a desired position as well as reporting a position in the user's coordinate system when the holding element is in a corresponding physical position. This avoids in particular errors in further processing the sample since the user is able to return to this physical position at any time by moving the holding element to the corresponding position in his coordinate system.

Moreover, the method provides a means for controlling and monitoring a position of a holding element without requiring recalibration when changing the sample, but instead using a calibration based on the sample type being used. Furthermore the error map and the correction map can be generated automatically, for example by using image recognition techniques and standard samples.

It should be noted that a correction of a position of the holding element can only be carried out by a movement of the holding element itself. The correction is not carried out by other means.

One preferred embodiment of the invention further comprises the step of storing the error map and/or correction map so that they can be used for example when changing the sample to be examined.

Moreover, the step of providing the error map comprises preferably taking into account an initial rotation and/or deformation of the reference object or sample which could also cause position errors. Furthermore, the step of providing an error map preferably comprises correcting a tilt of the reference object or sample. If there is some tilt in the reference object or sample, this could cause position errors. A way to compensate the effect of a tilt is by measuring of a focal length (necessary to generate a smallest particle probe on the sample) of the device at a number of positions of the reference object or sample and calculating the tilt using the different focal lengths measured. The result of the calculation can then be used to avoid the position errors. The errors with respect to the tilt are linear in effect and, therefore, can be removed by transformations such as the so called 3 point registration.

Preferably, the reference object is provided by a reference grid having at least one vertex being said first position. At least one further vertex given by a second position is also given by the grid or is determined by means of the first position, as is explained in detail further below. A grid can be obtained by converting arbitrary points to a grid (for example by interpolation). Moreover, it should be noted that the invention is not limited to grids. Using other reference objects is also possible.

One preferred embodiment of the method according to the invention comprises the step of measuring the deviation mentioned above visually, e.g. via means of an optical microscope or any other suitable optical means. However, it should be noted that determining the deviation(s) is not limited to visual measurement. Any other non-visual means suitable for determining the deviation(s) may also be used, for example an iterative process.

As mentioned above, the reference object is preferably provided by the sample itself. Alternatively, a separate reference object (not being the sample) is provided. The reference object is preferably designed as a grid. A grid having several grid points as reference positions might be preferably given. However, this does not mean that a complete grid must be provided by the reference object. Two grid points are sufficient for the invention. Further grid points can be determined by a calculation which is explained in detail further below.

The error map might be provided as follows. A reference object is given providing a grid with at least two vertices as grid points. One grid point is designed as a first position, and the other vertex is designed as (or the other vertices are designed as) a second position(s). The grid spacing between the vertices (i.e. the grid spacing in the x-coordinate and the grid spacing in the y-coordinate) can be measured and, therefore, is known. Nevertheless, the grid points of the grid can also be calculated and are defined as

$$X = X_0 + (GX * N) \qquad \text{[equation 1]}$$

$$Y = Y_0 + (GY * M) \qquad \text{[equation 2]}$$

whereby $X_0$, $Y_0$ represents the first position, N is iterated from 0 to the number of grid points in the direction of the x-coordinate, M is iterated from 0 to the number of grid points in the direction of the y-coordinate, GX is the grid spacing in the x-coordinate and GY is the grid spacing in the y-coordinate. One should note that equations 1 and 2 do not comprise the initial rotation, which will be explained further below. This method of providing calculated grid points is not limited to one specific position of the reference object as the basis. Any suitable position can be used. After having determined the further grid points, the errors at these grid points can be determined, e.g. they can be visually measured. Another method for providing grid points uses the top left corner of the grid as the first position. The grid spacing in the x-coordinate and the grid spacing in the y-coordinate are also given or measured.

The first position is chosen to have zero error. The reason why a zero error is acceptable for the first position is that any real error position would be a translation error of the entire error map. Since each position of the grid is taken relative to the first position (and the zero error), all errors of all grid positions will be translated by the actual real error of the first position. Since this is a constant translation over the entire reference object or sample, the assumption of the first position having zero error does not cause any problems.

The theoretical position(s) $X_T$, $Y_T$ of the grid points can be determined by using equations 1 and 2, wherein $X_0$, $Y_0$ is the first position. When positioning the holding element at $X_T$, $Y_T$, the holding element will take another position (the current or actual physical position) which is different to $X_T$, $Y_T$. Therefore, deviations between $X_T$, $Y_T$ and the actual physical position in the x-direction (eX) and in the y-direction (eY) are measured. The measured deviations eX, eY, the corresponding theoretical grid point $X_T$, $Y_T$ and/or the actual physical grid point are stored. Alternatively, an iterative process is performed to ensure maximum accuracy. First, the holding element is moved to $X_T$, $Y_T$, then deviations (errors) between $X_T$,$Y_T$ and the actual physical position in the x-direction ($eX_1$) and in the y-direction ($eY_1$) are measured. If the deviations are small (that means in a similar order of the absolute accuracy of the holding element), then $eX_1$ and $eY_1$ are stored. However, if the deviations are larger, the holding element is then moved to $X_T + eX_1$,$Y_T + eY_1$. Then the deviations of this position from the physical position are measured as $eX_2$ and $eY_2$. If these deviations are small, then $eX_1 + eX_2$, $eY_1 + eY_2$ is stored as the error for this theoretical and actual position. If these deviations are still large, the cycle is repeated. The iterative process is carried out for two reasons. First, simply measuring the error between where the holding element was requested to go and where it actually went does not necessarily provide with sufficient precision where it physically should match the theoretical position. Secondly, there may be errors in the measurement mechanism. If the measurement distance is reduced, then normally the measurement error is reduced.

The initial rotation is considered as follows. First, the initial rotation is preferably measured. Alternatively, the initial rotation is calculated. The following equations are applied when considering the rotation:

$$D = \sqrt{(N \times GX)^2 + (M \times GY)^2} \qquad \text{[equation 3]}$$

$$A = \tan^{-1}\left(\frac{N \times GX}{M \times GY}\right) \qquad \text{[equation 4]}$$

$$X = X_0 + D \times \cos(R + A) \quad \text{[equation 5]}$$

$$Y = Y_0 + D \times \sin(R + A) \quad \text{[equation 6]}$$

where R is the rotation of the grid.

It should be noted that the grid points do not need to be regularly spaced, as long as there is some way of determining the error at each point.

One embodiment of the invention comprises the step of providing the error map by means of interpolation, preferably by the method of Delaunay Triangulation. In particular, it is possible to determine more grid points which are not actually in the determined or given grid in each embodiment for providing the grid. This determination can be carried out by interpolation of further grid points and, additionally by their corresponding error(s)). One embodiment uses the method of Delaunay Triangulation and/or the method of inverse distance weighting as interpolation functions. The purpose of the Delaunay Triangulation is to take unevenly spaced points and to interpolate those to form a grid of evenly spaced points which are more suitable for use with smooth interpolation methods (for example bicubic interpolation, cubic splines) which require a grid. Thus, the mapping can then be used when the reference sample does not have evenly spaced features. First the existing points are triangulated, then it is necessary to determine a grid spacing and origin. The spacing and origin is calculated by using standard minimization algorithms that try to minimize the distance between new grid points and actual sampled points. The minimization function has four parameters, namely Origin X, Origin Y, Separation X, and Separation Y. These are modified iteratively and a quality of fit is measured. This is done by calculating the average distance squared from each sample point to the nearest grid point. Because this would tend to reduce the spacing parameters to the greatest common divisor of the sampled points (creating a vast number of grid points) the quality of fit also calculates the accumulated average distance squared of all grid points that are closer to a given sampled point than any other sampled point. This prevents an excessively fine grid spacing being generated, as it reduces the score as more grid points are introduced (with a tendency to provide the best scores when the ratio of grid points to sample points is near 1).

One preferred embodiment of the invention comprises the step of providing the correction map by means of interpolation. For example, the grid points and their corresponding errors are used for that interpolation. This interpolation preferably comprises polynomial interpolation such as interpolation functions based on bilinear, biquadratic, bicubic, and/or cubic splines and/or Delaunay Triangulation. This embodiment is preferably used in two steps. As described above, the first step comprises determining deviations of grid points (error map). The second step comprises determining deviations of any possible position (correction map) which is based on the deviations of the grid points determined in the first step. This second step is preferably done by the aforementioned interpolation to provide a correction map.

One further embodiment of the invention comprises the step of entering a desired position of the holding element in an input device. The holding element is then moved to the corresponding physical position according to the correction map.

Furthermore, the step of reporting preferably comprises the step of calculating the position in the second coordinate system by an iterative process. The reason is that the position returned from the holding element to the user must cause the holding element to move to the same position when the reported position is used as a desired position. One has to consider that the position S of the holding element in the user's coordinate system for a physical position P of the holding element suggested by a transformation from the first coordinate system to the second coordinate system (P → S) will change when using a transformation from the second coordinate system to the first coordinate system (S → P). In other words, P → S applied to X, Y gives X', Y', but S → P applied to X', Y' may not give back X, Y, but a new position X'', Y'' which is due to the errors introduced by the interpolation. Although, it is reasonable to assume that the difference between X,Y and X'', Y'' is small, it is still confusing for the user if he request a desired position X, Y and, after moving of the holding element, the position X'', Y'' is reported back. This problem is solved by the following solution. It is necessary to search for the position $X_u$, $Y_u$ in the user's coordinate system that will result in the currently physical position $X_p$, $Y_p$ of the holding element when error values for $X_u$, $Y_u$ are calculated. This can be done by solving the following equations

$$X_p - eX(X_u, Y_u) - X_u = 0 \qquad \text{[equation 7]}$$

$$Y_p - eY(X_u, Y_u) - Y_u = 0 \qquad \text{[equation 8]}$$

The simultaneous roots of equations 7 and 8 are found by routines, for example the iterative multidimensional Broyden secant method. This method basically evaluates the equations 7 and 8 and determines partial derivatives and then chooses a new value for $X_u$ and $Y_u$, until it has a value as close to zero as possible for both equations. The final value of $X_u$ and $Y_u$ is reported to the user. Another iterative method, which might be used, is the Newton Raphson method. On a modern desktop PC it is possible to determine the roots and the interpolation for example for 50000 positions in a few seconds, making this invention suitable for near real time use. The general multidimensional Broyden Secant method for finding roots of equations was originally described in Mathematics of Computation, Vol 19 pp 557-593 in 1965 by C.G. Broyden. The invention uses in particular a modified version of this (based on the routines described in Chapter 9.7 of Numerical Recipes in C, Cambridge University Press, 1992). However, the principles involved are the same and the exact mechanism used to find the roots of equation 7 and 8 is not important, as long as the process is sufficiently fast and accurate enough to be practical. The iterative methods (Newton/Broyden) require an initial estimate of the correct value and a mechanism for evaluating the current best value to see if the equation is at its root - i.e. zero. The process is as follows: An hardware reads a current physical position $X_p, Y_p$ and reports it to a software. The software must generate an $X_u, Y_u$ such that $X_p = X_u + eX(X_u, Y_u)$ and $Y_p = Y_u + eY(X_u, Y_u)$. The software uses a set of points as a starting point for the iterative methods. Multiple points are used in case the iterative method fails to converge or converges to a local minima which is not the global optimum solution (i.e. not sufficiently accurate). The base point is given by $X_u = X_p - eX(X_p, Y_p)$ and $Y_u = Y_p - eY(X_p, Y_p)$ which is the "naive" solution to the inversion of the map. As explained above, it is unlikely that this $X_u$ satisfies $X_u + eX(X_u, Y_u) = X_p$ as this would require (by substitution) that

$$X_p - eX(X_p, Y_p) + eX(X_p - eX(X_p, Y_p), Y_p - eY(X_p, Y_p)) = X_p Y_p - eY(X_p, Y_p) +$$
$$eY(X_p - eX(X_p, Y_p)),$$

$$Y_p - eY(X_p, Y_p) = Y_p$$

which would require

$$eX(X_p - eX(X_p, Y_p), Y_p - eY(X_p, Y_p)) = eX(X_p, Y_p).$$

$$eY(X_p - eX(X_p, Y_p), Y_p - eY(X_p, Y_p)) = eY(X_p, Y_p).$$

which is not generally true (it would be true if for example between $X_p$, $Y_p$ and $X_p - eX(X_p, Y_p)$, $Y_p - eY(X_p, Y_p)$ the derivative of eX and eY is zero).

However, if $eX(X_p, Y_p)$ is small and the rate of change of eX is small near $X_u$, $Y_u$ then this will be approximately true, and is good enough for a first guess for iterative methods, although it would not be good enough for display it to the user.

The first point is evaluated using

$$X_p - eX(X_u, Y_u) - X_u$$

$$Y_p - eY(X_u, Y_u) - Y_u$$

to form a result $X_u, Y_u$ represented as a two dimensional vector. This result is used by the respective iterative method to generate a new $X_u, Y_u$ which is again evaluated as above and so on. The generation of the new $X_u, Y_u$ is determined by the mechanism being used: Basically this typically involves projecting a gradient of the combined function towards a zero point and then evaluating the function at that new point. If the accuracy is sufficient then the method has to stop, otherwise the method projects the gradient again. The methods used also use some back tracking, limitation of travel and other techniques to improve reliability, but they are all widely known methods in a preferred embodiment.

If the iterative procedure fails to converge as described, then other starting points are tried. Failing to converge is determined by the process taking too long to reach a value of $X_u$ (and simultaneously $Y_u$) such that $X_p$ produced by $X_u + eX(X_u, Y_u) = X_p$ (or $Y_p$ from the "Y-version" of the equation) is greater than a predetermined acceptable distance from the $X_p$ or $Y_p$ measured. Additionally, singular matrices may occur during the evaluation of the iterative methods (basically the mechanism will require a divide by zero to determine the next point), which will result in another starting point being required, or the iterative methods may fail to be improving the value of $X_u$, $Y_u$. In any of these cases a new point is taken which is distinct from any previous starting point and within the range of error from the base point. The selection of such new starting points, whilst not random, is arbitrary. In principal it is possible for the iterative mechanisms to fail to converge from all attempted starting points thus breaking the mapping so that the reported $X_u$, $Y_u$, will not result in $X_p$, $Y_p$ but in practice this does not occur (this would typically require for example a surface is extremely uneven, producing areas that cannot be inverted, given the mathematical precision of the CPU - for a physical holding element errors will vary smoothly and thus avoid such pathological cases). If convergence is not achieved then the best value that was found during all iterations is used.

One further embodiment of the invention comprises an implementation of a multi-axis interpolation. This embodiment comprises the step of providing the correction map for the holding element being tilted around an axis. If correction maps are created for the holding element being tilted for example at 0°, 10° or 20°, then the correction of the physical position and of the position in the user's coordinate system at a given holding element coordinate at tilt angles of, for example, 5° and 15° can be derived by interpolation in each of the provided correction maps. The interpolation is preferably a non linear cubic spline interpolation. Such interpolation is able to cope with changes of several axes (for example changes in the z-direction or rotation of the holding element, in addition to the tilt of the holding element). Typically, only a single additional axis is considered - in particular the tilt axis (T). Occasionally, a rotational axis (R), a vertical movement axis (Z) and orthogonal movement axis (M) may need to be considered. The position of these axes is assumed to be correct and not in need of independent correction. However, as the tilt, vertical position etc. is changed, the loading of the holding element hardware changes, causing position errors in X and Y.

It is now described how the mapping works with a single additional axis in a preferred embodiment, and then it is discussed how more axes can be added. It is only necessary to consider how an axis $X_p$, $Y_p$ is generated from a user request $X_u$ $Y_u$ (i.e. how eX(Xu, Yu) is evaluated), because as in the 2-dimensional case, the reverse translation is determined by an iterative process calculating $X_p$, $Y_p$ from testing $X_u$, $Y_u$ values determined iteratively by a generic method. If only a single correction map is available then the additional axis data is ignored. If multiple correction maps (e.g. at 5°, 10°, 20°, 30°) are available then the following process is used.

If the axis position of the independent axis (e.g. the tilt axis) is below the axis position of the lowest correction map, then the system ignores all but the lowest map and returns a value as if in the 2-dimensional case from the lowest map. It is done similarly if the position is above the highest map. Otherwise, eX($X_u$, $Y_u$) is calculated from every correction map in that axis. These eX values are converted to cubic splines and the value is interpolated at the current axis (tilt) position to give a new eX($X_u$, $Y_u$). This is done similarly for eY.

If there are more axes to consider then there are two possible approaches. The preferred method is to consider the effects of the axes independently. Thus, setting a position T will add a certain error to a given position and setting a position Z will add another error to the same position, providing a combined error. Thus, the position $X_p$, $Y_p$ is considered to made of ($X_u$ + eXZ + eXT, Yu + eYZ + eYT), with eXZ, eYZ, eXT, eYT are errors of the axis mentioned above and are considered independent, meaning that, for example, changing Z will not alter the value of eXT. If this assumption is made then this reduces considerably the amount of calculation required. A first correction map is made at position (T = T1, Z = Z1). The exact values of T1 and Z1 are not important. Further correction maps are made at (T = T2, Z=Z1), (T = T3, Z = Z1) and so forth. However, Z remains unchanged. Then correction maps are made at (T = T1, Z = Z2), (T = T1, Z = Z3) and so on. However, T remains unchanged. The correction maps are stored as a set with each axis, every axis stores the first map plus all maps taken where that axis was changed. So in this example if 5 tilt values were used and 4 Z values were used there would be 8 maps (as there is one map included in both), with axis T would be stored 5 maps and with axis Z would be stored 4 maps. To calculate $eX(X_u, Y_u, T, Z)$, $eY(X_u, Y_u, T,Z)$ the single additional axis method is used as above for Z and T. Thus, N values for $eX(X_u, Y_u)$ and $eY(X_u, Y_u)$ are produced where N is the number of axes - in this example 2. To combine these values it is necessary to look again at the components of error. If the correction values from each axis were simply added, then the result would be erroneous. This is because correction map values for Z have a component from T1 in them (eXT1, eYT1) which is already present in the correction map values for T and similarly the T maps have the component from Z1. To remove this from eX, the sum of eXT1 + eXZ1 is needed. This is available in the correction map taken at T = + T1 and Z = Z1. Thus the values eXT1Z1, eYT2Z1 are calculated from this map and subtracted from the sum of all other axes. Thus, the multidimension values for eX, eY are

$$eX_{map}(X_u, Y_u) = \left( \sum_{n=1}^{N} eX_n(X_u, Y_u) \right) - (N-1)eX_0(X_u, Y_u)$$

$$eY_{map}(X_u, Y_u) = \left( \sum_{n=1}^{N} eY_n(X_u, Y_u) \right) - (N-1)eY_0(X_u, Y_u)$$

where $eX_0$ $eY_0$ is the first correction map taken at the starting position for all axes. N represents the axes 1 to number of axes. $eX_n$ $eY_n$ are the error values that would be returned for the single axis interpolation. With the assumption of axis independence, the number of maps is in effect increased only linearly with each additional axis and the number of calculations grows similarly.

One should note that these do not need to be physical axes on the holding element, but could be environmental factors such as stage loading (loading of the holding element). For example weighted sample blocks can be added to the holding element (stage) to simulate different sample weights and correction maps recorded at each of these weightings. The weights are then removed. The sample can then be weighed and then the "weight axis" can be set to the weight of the sample.

If it is determined that the axes are not independent (e.g. combining the hypothetical weight axis above with a tilt axis), then maps must be generated for each combination of axis values. This gives larger growth in complexity and number of maps required as the number of axes is increased. In practical terms this means that only a few additional axes can be implemented. It is required to generate splines for each in this case to calculate eX, eY. For example, if there are correction maps for T = 0°, 10°, 20°, 30° and each combination with Z = 5, 15, 25 then there are 12 maps in total. Getting a value eX for T = 15, Z = 20 , X = 5, Y = 10 requires calculating eX(5, 10) on every correction map. This creates a new surface x = T, y = Z, z = eXTZ(5, 10). First N splines are created with x, z pairs. (i.e. T, eXTZ pairs). All of these are then interpolated to create M new values at T = 15. These new values are formed into a spline and interpolated at Z = 20. That gives the final eXTZ. By using splines to interpolate in one dimension at a time and then forming a spline in the next dimension from the results, this method can be expanded into any number of axes in an automatic fashion; however, it is obvious that even with a few axes a lot of maps and a lot of calculations are required, especially when iterative inversion is used.

Another embodiment of the invention comprises during the step of providing the error map the step of correcting errors due to temperature influences. Since many grid positions can be examined during providing the error map, requiring several movements of the holding element, thermal effects can cause temporary positioning errors as the holding element is warmed beyond normal use. To compensate for this, the current first position (current point zero) is periodically measured and compared to the original first position. If there is any difference, the difference is then removed from the measured/calculated positions.

One further embodiment of the invention uses a light overlay reference sample as a reference object. A light manufactured reference sample can be used to get a baseline correction map for the holding element. The light reference sample can be mounted on top of another sample of the user. Since the weight of the reference sample is low in comparison to the user's heavy sample, the error map and correction map provided with the light reference sample mounted on another sample are, in principal, still accurate when compared to those without it. This reference sample can comprise features that make it easy to provide the error map or the correction map, for example a combination of large and small features regularly spaced and easily recognisable.

One further embodiment of the invention comprises the step of storing the error map and providing a correction map only during later applications of the method for controlling and monitoring the holding element. Alternatively, the error map and the correction map are stored, and the stored correction map is used during later applications of the method. One further embodiment of the invention comprises the steps of providing a plurality of sample loads and providing an error map and a correction map for each of the sample loads. When a sample is used in later applications, one error map of the error maps and/or one correction map of the corrections maps is used which fits best to this sample.

A further embodiment of the invention comprises providing several first positions and providing the error map as well as the correction map for each of said several first positions.

The invention also refers to a recordable medium comprising an executable code, wherein the executable code comprises a method, the steps of which comprise at least one of the method features as mentioned above. The executable code can be carried out by at least one microprocessor.

The invention also refers to a device for controlling and monitoring a position of a holding element, wherein the holding element is provided to hold a sample to be examined. The device is capable of carrying out in particular a method comprising at least one of the steps mentioned above. The holding element is part of the device and takes a physical position in a first coordinate system when it is in a corresponding position in a second coordinate system. The device further comprises a means for providing at least one first position in the second coordinate system as a reference point. The first position is provided by a reference object and the holding element takes a first physical position in the first coordinate system when it is in the first position in the second coordinate system. Furthermore, the device comprises a means for providing at least one error map by means of the at least one first position. The error map comprises a deviation of at least one second physical position of the holding element in the first coordinate system from a corresponding position of the holding element in the second coordinate system. Moreover, the device comprises a means for providing at least one correction map by means of the error map, wherein the correction map comprises a deviation of at least one third physical position of the holding element in the first coordinate system from a corresponding position of the holding element in the second coordinate system, wherein the correction map provides a non-linear coordinate translation between the first coordinate system and the second coordinate system. Additionally, the device comprises a means for moving the holding element to the third physical position in the first coordinate system corresponding to the desired position in the second coordinate system according to the correction map, and/or a means for reporting the position in the second coordinate system corresponding to the third physical position in the first coordinate system by means of the correction map.

One preferred embodiment of the device comprises at least one storing unit and/or at least one microprocessor.

Preferably, the device comprises a reference object which is designed as a reference grid having at least one vertex being the first position. The reference object can be designed as the sample to be examined.

The device according to a further embodiment of the invention comprises with respect to the error map a means for determining the deviation of the at least one second physical position of the holding element in the first coordinate system from the corresponding position of the holding element in the second coordinate system by means of interpolation.

Also, the device preferably comprises with respect to the correction map a means for determining the deviation of the at least one third physical position of the holding element in the first coordinate system from the corresponding position of the holding element in the second coordinate system by means of interpolation.

Furthermore, the device preferably comprises an input device and an output device.

The invention also refers to a beam device, in particular a particle beam device, comprising a beam generator that generates a beam; an objective lens that focuses the beam on an object (sample) being held by a holding element; and a device for controlling and monitoring a position of said holding element and having at least one of the features as mentioned above. Preferably, the beam device is designed as an electron beam device, such as a scanning electron microscope or a transmission electron microscope. The device can also be designed as an ion beam device or any other particle beam device.

One further advantage of the invention is that the values stored as mentioned above can be used as a diagnostic tool for the device having the holding element. If the values currently stored are different from the values of a further measurement/calculation, there may be some problems with the device.

The invention will now be described based on preferred embodiments shown in the accompanying figures.

Fig. 1    is a schematic drawing of a scanning electron microscope;

Fig. 2    is a schematic drawing of a part of a transmission electron microscope;

Fig. 3    is a schematic drawing of a part of a beam device;

Fig. 4    is a flow chart showing preferred method steps;

Fig. 5        is another flow chart showing further preferred method steps;

Fig. 6        is a schematic drawing of a grid with initial rotation;

Fig. 7a,b     are schematic drawings of reference objects;

Fig. 8        is a flow chart showing preferred method steps;

Fig. 9        is another flow chart showing preferred method steps, and

Fig. 10       is a further flow chart showing preferred method steps.

The invention will now be described with respect to beam devices, in particular to two electron beam devices. One should note that the invention is not limited to electron beam devices, but can be arranged and/or used in any device requiring the control of a position of a movable part, in particular in any particle beam device.

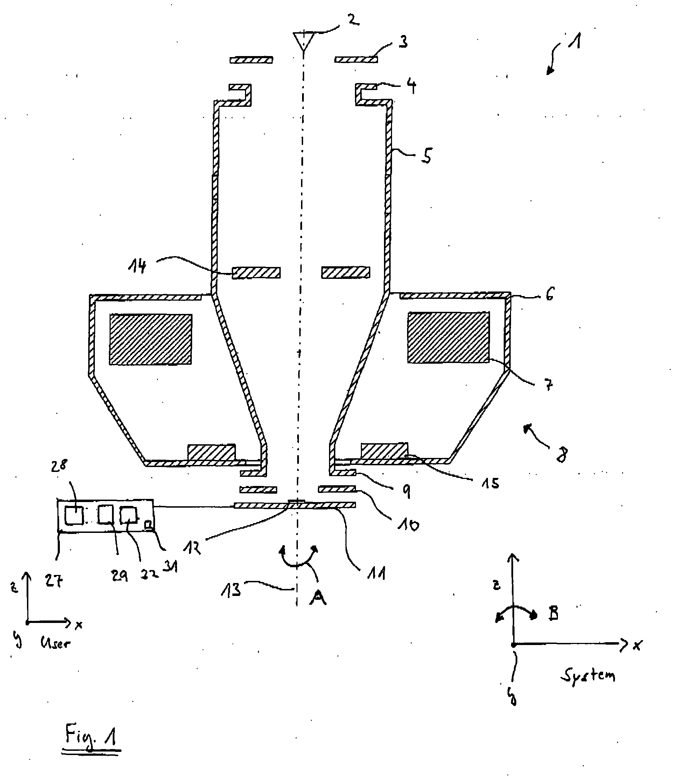

Fig. 1 shows a schematic drawing of a scanning electron microscope 1 (hereinafter also referred to as SEM). The SEM 1 comprises an electron gun 2 providing electrons. The electron gun 2 is designed as a cathode, preferably as a field emitter. Furthermore, the SEM 1 comprises an extraction electrode 3 and a further electrode 4 designed as an anode. The electrons emitted by the electron gun 2 are accelerated to the potential of the anode due to a potential difference between the electron gun 2 and the electrode 4. The electrode 4 is also one end of a beam guiding tube 5 which is arranged in a bore of an objective lens 8. The objective lens 8 comprises pole shoes 6 having coils 7. A deceleration unit is arranged in the direction of the optical axis 13 of the SEM 1, starting from the electron gun 2. This deceleration unit comprises an electrode 9 being a further end of the beam guiding tube 5 and a single electrode 10. The electrode 9 has anode potential like the beam guiding tube 5, whereas the single electrode 10 as well as a sample 12 arranged on a holding element 11 have a potential which is less than the anode potential. This enables the electrons provided by the electron gun 2 to be slowed down to a desired low energy which is suitable for a desired examination to be carried out by a user. The beam guiding tube 5 also comprises scanning means 15 which provide scanning of the electrons over the sample 12.

The holding element 11 is movable in three directions in space, namely the x-the y- and the z-direction as schematically shown in Figure 1. Each direction is perpendicular to each other direction, as schematically shown in Figure 1. Additionally, the holding element 11 can be rotated about the optical axis 13 of the SEM 1, as schematically shown by arrow A. Furthermore, the holding element 11 is tiltable about the z-direction, as schematically shown by arrow B. The movement of the holding element 11 is controlled by a controlling device 27 comprising a memory unit 28 and a microprocessor 29. The controlling device 27 also comprises a display 32 and is also designed as an input device. Therefore, a user is able to input commands into the controlling device 27 and sees inputs and further information (like the position of a sample) on the display 32. Additionally, the controlling device 27 comprises a recordable medium 31 comprising executable code of a method which will be described below.

The SEM 1 also comprises a detector 14 which detects electrons resulting from an interaction of the electrons scanned over the sample 12. The detected electrons are backscattered electrons (BSE) and secondary electrons (SE). This detector 14 is used for providing an image of the sample 12.

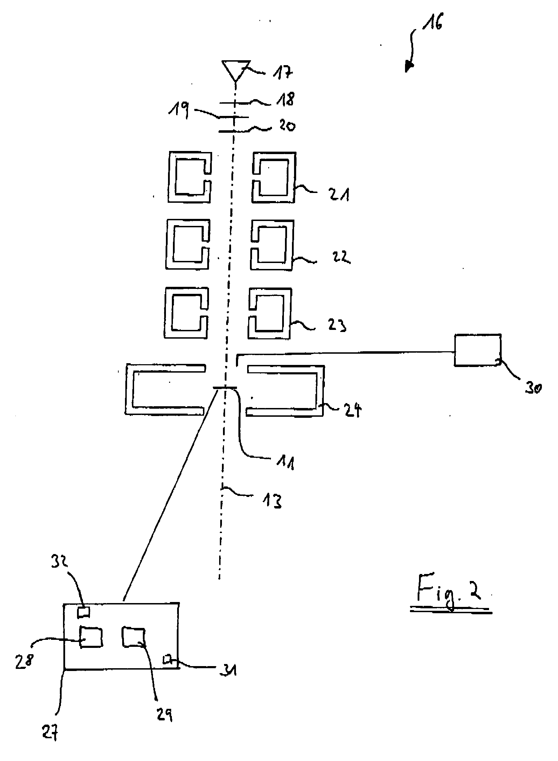

Figure 2 shows another example of a beam device having a movable holding element 11 for a sample to be examined. This beam device is a transmission electron microscope 16 (hereinafter also referred to as TEM). Figure 2 only shows an upper part of the TEM 16 comprising an electron source 17 in the form of a field emitter. In the direction of the optical axis 13, the TEM 16 also comprises electrodes 18, 19 and 20. The electrode 18 has a potential capable of extracting electrons from the electron source 17. The electrode 19 is capable of focussing the source position and the electrode 20 is capable of accelerating electrons provided by the electron source 17 to a desired potential. Furthermore, the TEM 16 comprises a multi-stage condenser having three magnet lenses 21, 22 and 23 followed by an objective lens 24. The objective lens 24 comprises a sample plane in which the holding element 11 is arranged. The holding element 11 is identical to the holding element 11 of Figure 1 and is controlled by the same controlling device 27 as mentioned above. Therefore, it is also movable as described above. The TEM 16 also comprises a means 30 capable of visually measuring distances on a sample.

Since TEMs in general are well known in the art, further details are not described, in particular not the part of a TEM arranged behind the objective lens 24 in the direction of the optical axis 13.

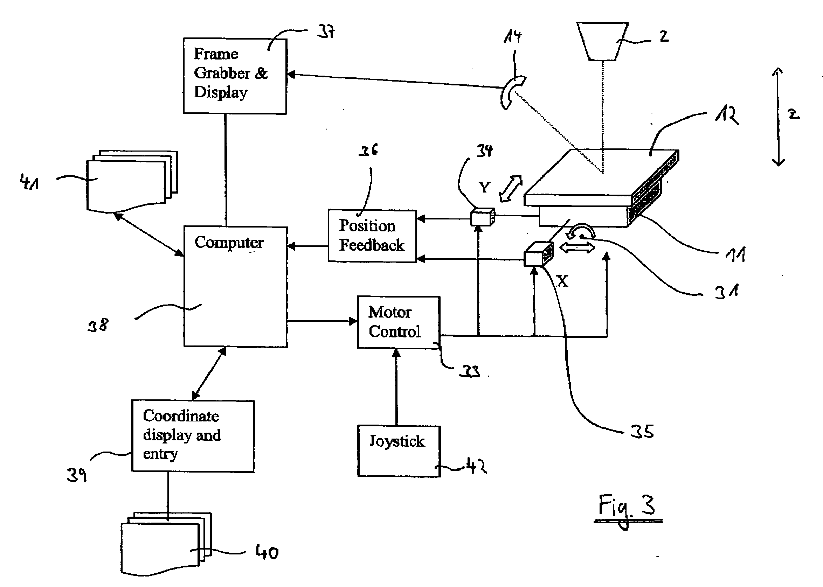

Figure 3 shows another schematic drawing of the device shown in Figure 1. The features shown in Figure 3 can also be features of the device shown in Figure 2. The electron beam is generated by the electron gun 2. The sample 12 is mounted on the holding element 11. The sample 12 is a piece of material, for example a glass mask used in lithography or a silicon wafer with microchips. The sample 12 has mass and possible magnetic properties that may distort the position of the holding element 11. The sample 12 does not need to be flat, it might have any shape.

The holding element 11 is motorized and driven by motors 34 and 35 as well as motor control 33, moving the holding element 11 in the x-direction and y-direction, respectively. Furthermore, the holding element 11 can be tilted around tilt axis 31. The holding element 11 can also be moved in the z-direction being perpendicular to the x-direction and y-direction. Furthermore, the holding element 11 can be rotated around the axis in the z-direction.

The motorized holding element 11 allows the user to position an area of interest of the sample 12 under the electron beam. As mentioned above, the weight of the sample 12 can influence the holding element 11 to move or bend by small amounts, thus changing the position under the electron beam. In addition, irregularities in the construction of the holding element 11 and/or the motors 34 and 35 and/or the motor control 33 can cause position errors of the holding element 11.

The holding element 11 can be moved via a computer 38 having an input device as shown in Figure 1 or via a joystick 42. However, the holding element 11 might be moved by any other possible means, in particular means which are not controlled by the computer 38.

The motor control 33 converts the position information from the computer 38 (for example a position desired by the user and entered into the input device) into signals to move the motors 34 and 35 to the precise location as requested and according to a correction, as explained further below. In addition, motor control 33 accepts signals from the joystick 42 to directly move the holding element 11 without computer control.

The device also comprises a position feedback 36 converting signals from the motors 34 and 35 (or motor encoders not shown) and converting them to position information for the computer 38. The computer 38 can detect the position of the holding element 11 and can report the position of the holding element 11, even if the holding element 11 has been moved independently from the computer 38. In a further embodiment (not shown), the feedback position 36 and the motor control 33 are embodied in one single unit.

The detector 14 detects electrons (secondary electrons or backscattered electrons) from the sample 12. The detector 14 converts detection signals into digital information. This digital information takes the form of an image of the sample 12 (area of sample 12) being irradiated by the electron beam. A frame grabber/display 37 takes this information and stores it. Moreover, it displays the image to the user.

One further unit of the device is the coordinate display and entry unit 39. To navigate to points of interest (positions of interest) on the sample 12 the user (or an automatic user software) enters coordinates of a desired position. This may be a desired position stored in a file of an optical defect classification system 40 or a position directly entered by the user into the input device. Furthermore, the user can move the holding element 11 with the joystick 42. If the user sees a feature of interest, he can record the position of this feature so that he can examine this feature later. It should be noted that the user could be in fact an automated process or a human being.

The device also comprises a holding element mapping unit 41 which comprises previously stored relationships (error map and/or correction map) between requested holding element positions and actual physical positions of the holding element 11 that are used to find the correct position.

The computer 38 converts the position information from the position feedback 36 into coordinates of the user's coordinate system for display. In addition, it converts position coordinates entered by the user into signals for the motor control 33 to move the holding element 11 to the corrected requested desired position. This is done by a non-linear translation. However, the user only ever sees and enters position coordinates according to this translation which is explained further below.

The embodiment of the invention explained below is used in the devices of Figures 1, 2 and 3. First, an error map is provided by determining and storing deviations relating to a grid for specific grid points, those grid points and deviations being the basis for the determination of any deviation of any position of the holding element 11 which can be found in a correction map.

The embodiment mentioned below refers to movements of the holding element 11 in the plane defined by the x-direction and y-direction. However, the invention is not limited to such movements. In fact, the invention also refers to any other movement, in particular to any other linear, rotational or tilt movement of the holding element.

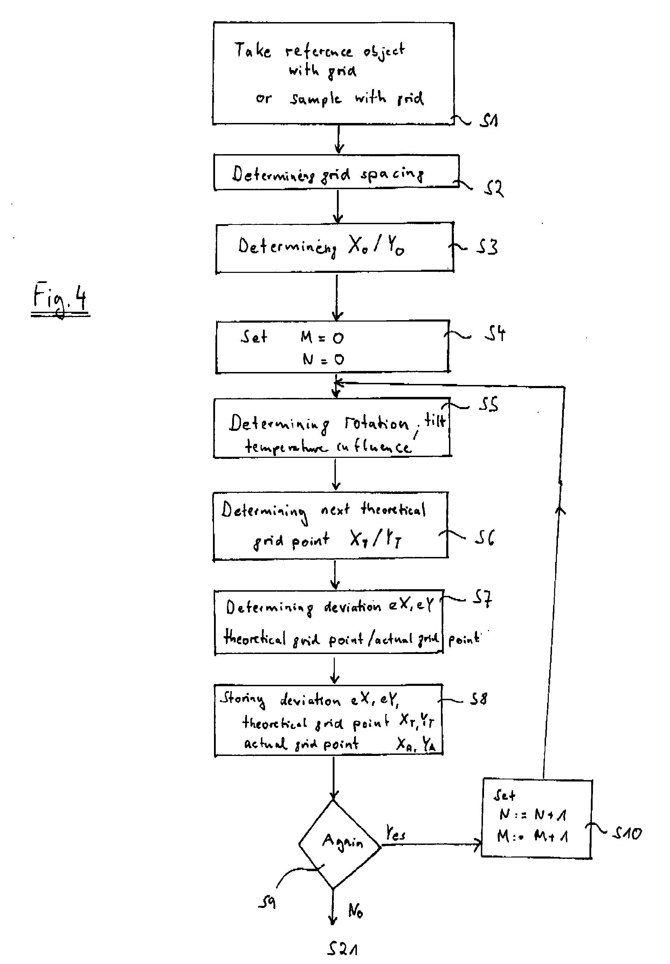

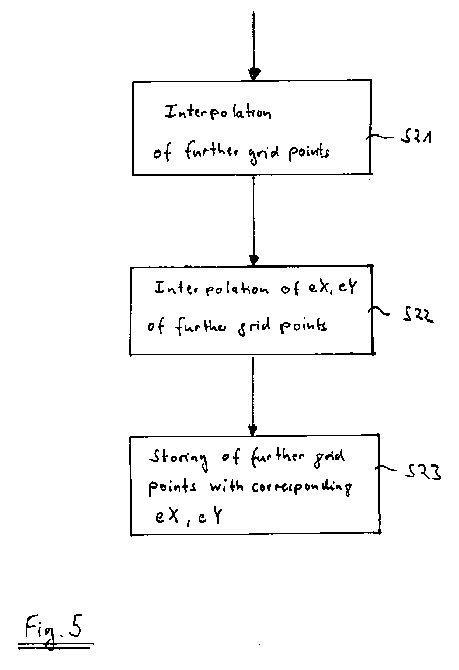

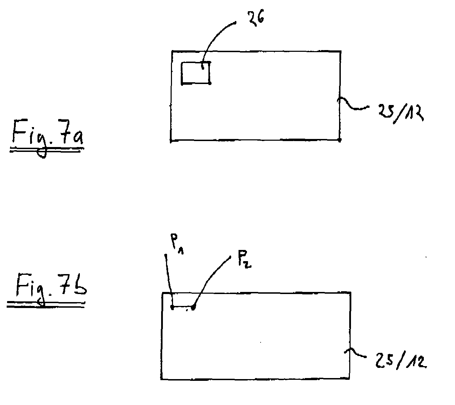

Figures 4 and 5 are flow charts explaining the inventive method with respect to the deviations of grid points. In step S1, a reference object comprising a grid is arranged at the holding element 11. Figure 7a shows one example of a reference object 25 having a grid 26. Please note that it is not necessary for the invention to have a reference object 25 separate to the sample 12 to be examined. As already mentioned above, the sample 12 can itself be the reference object 25 comprising the grid 26, for example the light overlay grid as mentioned above.

In step S2, the grid spacing between the given grid points is determined, e.g. by visually measuring the spacing between the grid points in the x-direction (grid spacing GX) and in the y-direction (grid spacing GY). This can be done by imaging via the detector 14 of the SEM 1 or by means 30 of the TEM 16. Following step S2, a first position $X_0,Y_0$ is determined. This can be any grid point on the given grid 26. Preferably, the first position $X_0,Y_0$ is given by the top left corner of the grid 26. In step S4, two variables, namely N and M are set to zero. N is iterated later on from 0 to the number of grid points in the direction of the x-coordinate, whereas M is iterated from 0 to the number of grid points in the direction of the y-coordinate.

As mentioned above, the grid 26 might have an initial rotation R which has to be taken into account. This rotation is determined in step S5 by measuring the rotation or by calculating the rotation by suitable algorithms. Furthermore, a possible temperature influence on the holding element 11 is determined in step S5. If there is any temperature influence, it is corrected in step S5 as mentioned above. Additionally, in step S5, if there is some tilt in the reference object 26 or sample 12, this could cause position errors. A way to compensate the effect of a tilt is by measuring of a focal length (necessary to generate a smallest particle probe on the sample) of the device 1, 16 at a number of positions of the reference object 26 or sample 12 and calculating the tilt using the different focal lengths measured. The result of the calculation can then be used to avoid the position errors. The errors with respect to the tilt are linear in effect and, therefore, can be removed by transformations such as the so called 3 point registration. After having concluded step S5, the next theoretical grid point $X_T$, $Y_T$ is determined in step S6. This is done by using the equations 5 and 6. When positioning the holding element 11 at $X_T$, $Y_T$, the holding element 11 will take another position (namely the current or actual physical position $X_A$, $Y_A$ at which a further given grid point of the grid is arranged) which is different from $X_T$, $Y_T$. Therefore, deviations between $X_T$, $Y_T$ and the actual physical position $X_A$, $Y_A$ in the x-direction (eX) and in the y-direction (eY) are measured in step S7 (e.g. via imaging with detector 14 in the SEM 1 or by means 30 of the TEM 16). This can also be done by using the iterative process mentioned above to ensure a more accuracy.

In a following step S8, the measured deviations eX, eY, the corresponding theoretical grid point $X_T$, $Y_T$ and the actual physical grid point $X_A$, $Y_A$ are stored in the memory unit 28 of controlling device 27 (Figures 1 and 2) or the holding element mapping unit 41 (Figure 3). Steps S6 to S8 are repeated for any given grid point of grid 26, and the variables N and M are increased in increments of one for any further grid point.

In this embodiment of the invention, it is desirable to have more grid points than already given by the grid 26. Therefore, further grid points not originally in the grid 26 are determined by means of interpolation (see Figure 5, step S21). Step S21 comprises the calculation of an optimum spacing between the given grid points, thereby minimizing the distance between the grid points and points of interest to be examined. Interpolation is carried out by the procedure known as Delaunay Triangulation which is used for connecting the grid points with a series of lines so that every grid point is a vertex of at least one triangle, and no triangles overlap. Step S22 is carried out after step S21 which provides the deviations eX and eY at each interpolated grid point. For determining eX and eY at one specific grid point, the triangle enclosing the specific grid point is found and a plane is formed using the deviations at the grid points determined in steps S1 to S10. The deviations cX and eY at that specific grid point is then determined by means of the plane. For specific grid points lying outside the convex hull determined by the Delaunay Triangulation, an interpolation based on inverse distance weighting is used. The specific grid points and their corresponding deviations eX and eY are stored in the memory unit 28 of the controlling device 27 (step S23) or the holding element mapping unit 41.

Where reference marks are not evenly distributed across a sample or where parts of the sample do not contain reference marks, the reference marks are not necessarily arranged in a grid fashion, they are converted to a grid by interpolating from the triangulation. Then this grid is what is used for the error map stage later on. This means that random points are taken and are converted to a grid by determining an ideal spacing and origin. Then, the points are triangulated and a value is taken from the plane of the triangle that intersects with the grid point. This gives a grid that is suitable for use with cubic splines/bicubic interpolation.

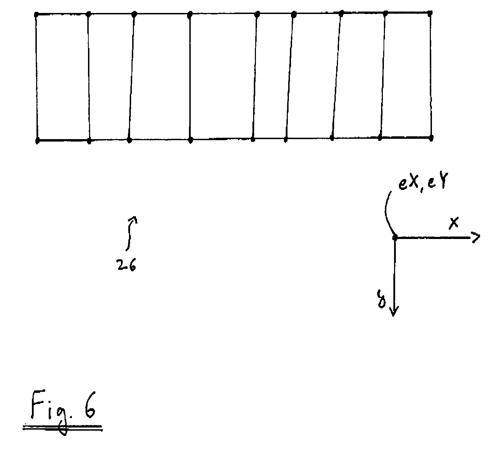

Figure 6 shows a schematic view of an embodiment of the grid 26 comprising several vertices and lines connecting the vertices. As mentioned above, the grid 26 can have an initial rotation and the grid spacing between the vertices might not be regular, as shown by some of the lines connecting the vertices. Any of the vertices shown can be the first position $X_0$, $Y_0$.

Determining the grid of this embodiment is not limited to a reference object comprising a grid with several grid points. In fact, two grid points, namely $P_1$ (given by $X_1$, $Y_1$) and $P_2$ (given by $X_2$, $Y_2$) having a specific distance from each other, are sufficient to carry out the steps as mentioned above. A reference object 25 and a sample 12, respectively, comprising positions $P_1$ and $P_2$ are shown in Figure 7b.

The method mentioned above can be repeated for further first positions $X_0$, $Y_0$. An error map based on a grid is provided for each of the first positions and the method is repeated starting from step S1 or step S3.

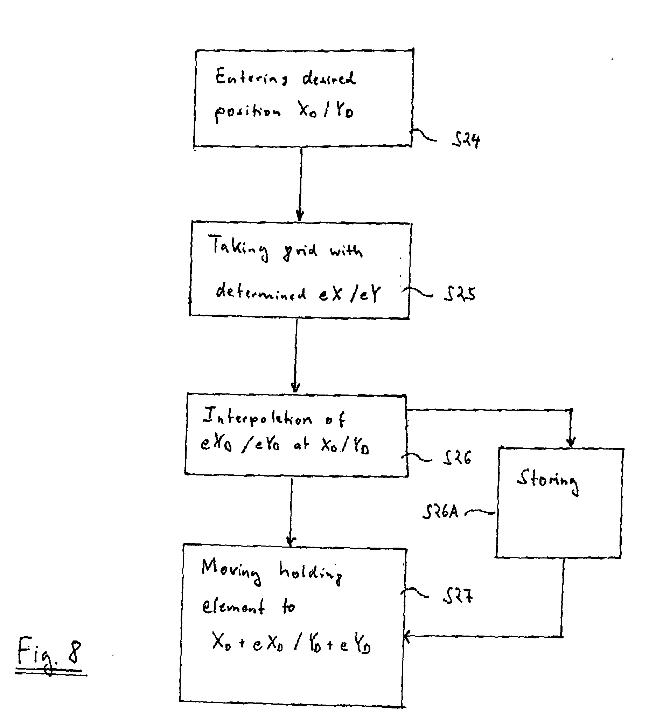

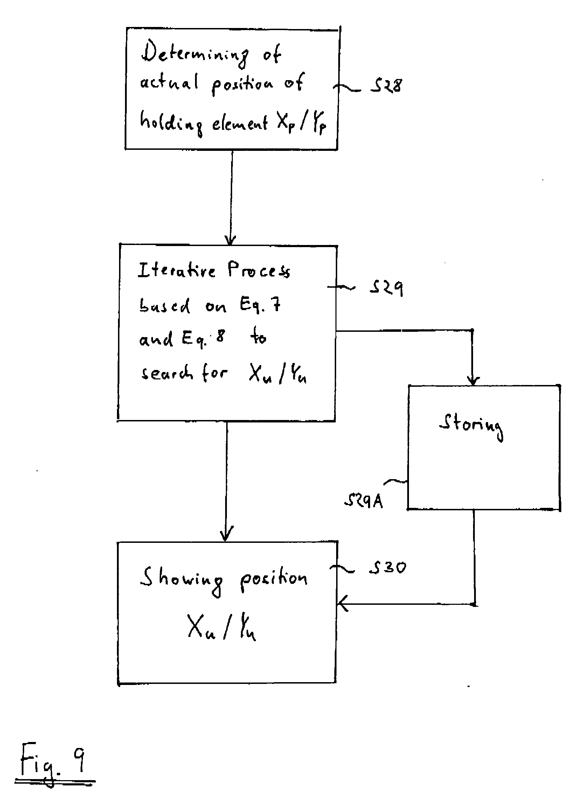

The above mentioned determined grid points and their corresponding deviations eX and eY stored in the memory unit 28 and holding element mapping unit 41 are used for providing a correction map, i.e. to determine any deviation at any position X,Y. This is done for the first position $X_0$, $Y_0$ or for each first position $X_0$, $Y_0$ (if there is more than one). Providing the correction map is further explained with the flow charts shown in Figures 8 and 9. Figure 8 shows a flow chart of the steps involved when a desired position $X_D$, $Y_D$ of a sample 12 is entered in the controlling device 27 or the computer 38 by a user (step S24). Then, the error map based on the grid points and the deviations determined in the first step are taken (step S25) and are the basis for an interpolation of the deviations $eX_D$ and $eY_D$ for the desired position $X_D$, $Y_D$ (step S26). The interpolation used in this main step is a polynomial interpolation. In one particular embodiment, when $X_D$, $Y_D$ is requested, the determined grid is checked to find the 16 grid points that surround $X_D$, $Y_D$ in a 4 by 4 "mini-grid", with $X_D$, $Y_D$ lying in one of the central squares. If this lies outside the given grid points, the deviations $eX_D$ and $eY_D$ for $X_D$, $Y_D$ are determined using inverse distance weighting, whereas the $eX_D$ and $eY_D$ are taken from the stored values corresponding to the given grid points if $X_D$, $Y_D$ lies inside the given grid points.

The aforementioned is now explained in more detail. Each line of the "mini-grid" in the x-direction comprises 4 points. For each line a cubic interpolation is calculated for the X-value of $X_D$. That means a cubic polynomial is determined that passes through the correct eX at all four points, and $eX_D$ at $X_D$ is calculated for that polynomial. This yields four more points (one for each line). The cubic polynomial that fits these points is calculated and solved for the Y-value of $Y_D$. This gives $eY_D$.

Instead of the 16 point bicubic interpolation, a bicubic splines interpolation might also be used. This provides a globally smoothed function that normally leads to better results. The cubic splines embodiment functions as follows.

When the points have been converted into a regularly spaced grid of dimension N*M (N and M are integers), N cubic splines are created using the value of eX (or eY) at each value of Y in an X column. To generate a spline in a column, the software determines a cubic function between each two consecutive values such that at the ends of the cubic the second derivative is zero and across the entire set of splines the second derivative has no discontinuities and the first derivative at the edge of each section matches that of the next cubic spline section and that has a value at each section boundary that matches the recorded values. This provides a smooth continuous function, along the entire length of the spline. When a position is requested, each of the N cubic splines is evaluated at $Y = Y_D$. This gives a set of M values eX1, eX2, ... eXM. This set of values is used to create a new spline across the columns. This spline is then evaluated at $X = X_D$, which provides a new value of eX. This is determined similarly for eY.

After having determined $eX_D$ and $eY_D$ for $X_D,Y_D$, the holding element 11 is moved to $X_D + eX_D/Y_D + eY_D$, corresponding to the $X_D$, $Y_D$ desired by a user (step S27). Alternatively, before moving the holding element 11, the interpolated values are stored in step S26A for the purpose of using them in later applications.

Figure 9 shows the method used when reporting an actual physical position $X_P,Y_P$ to a user in coordinates of the user's coordinate system. After having determined the actual physical position $X_P$, $Y_P$ (step S28), the corresponding coordinates $X_u$, $Y_u$ are searched (step S29) by the iterative process mentioned above using equations 7 and 8 and are shown in step S30 after finding the right values. Before showing them, the found values can be stored in step S29A. The simultaneous roots of equations 7 and 8 are found by routines, for example the iterative multidimensional Broyden secant method. This method was described above and basically evaluates the equations 7 and 8 and determines partial derivatives and then chooses a new value for $X_u$ and $Y_u$, until it has a value as close to zero as possible for both equations. The final value of $X_u$ and $Y_u$ is reported to the user. Another iterative method, which might be used, is the Newton Raphson method.

The above mentioned steps are all controlled by the microprocessor 29 of the controlling device 27 or the computer 38. This microprocessor 29 or computer 38 also controls the movement of the holding element 11. As mentioned above, the holding element 11 can in principle also be moved without using the microprocessor 29 or the computer 38 (for example by some external interface). However, the microprocessor 29 or the computer 38 must have knowledge of the current physical position of the holding element 11 even if the holding element is not moved by the microprocessor 29 or the computer 38.

The method described above might be carried out in two ways: One way comprises storing the error map and providing a correction map only during later applications of moving and monitoring the holding element. In the other way, the error map and the correction map are stored before the application, and the stored correction map is used during later applications of the method. The method described above is also carried out in the following way: a plurality of sample loads is provided. Then, an error map and/or a correction map for each of these sample loads is/are provided. Therefore, a plurality of error maps and/or correction maps is/are provided. Then, one error map of these error maps and/or one correction map of these corrections maps is used for moving the holding element 11 and/or for reporting the position of the holding element 11 in the coordinate system of the user.

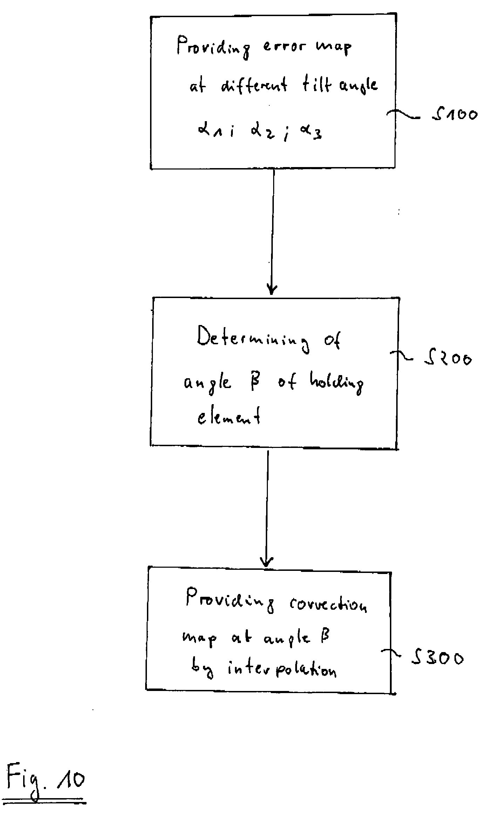

One further embodiment of the invention comprises an implementation of a multi-axis interpolation which is shown in Figure 10. This embodiment comprises the step of providing the correction map for the holding element 11 being tilted around the axis 31 and which was described further above. If correction maps are created for the holding element 11 being tilted for example at 0°, 10° or 20°, then the correction of the physical position and of the position in the user's coordinate system at a given holding element coordinate at tilt angles of, for example, 5° and 15° can be derived by interpolation. Error maps at different tilt angles $\alpha_1$, $\alpha_2$ and $\alpha_3$ are provided in step S100. A tilt angle $\beta$ of the holding element 11 is provided in step S200. Then, the correction map for angle $\beta$ is given by interpolation. The interpolation is preferably a non linear cubic spline interpolation. Such interpolation is able to cope with changes of several axes (for example changes in the z-direction or rotation of the holding element in addition to the tilt of the holding element).

**Reference signs list**

1  scanning electron microscope

| 2 | electron gun |
|---|---|
| 3 | electrode |
| 4 | electrode |
| 5 | beam guiding tube |
| 6 | pole shoe |
| 7 | coil |
| 8 | objective lens |
| 9 | tube electrode |
| 10 | single electrode |
| 11 | holding element |
| 12 | sample |
| 13 | optical axis |
| 14 | detector |
| 15 | scanning means |
| 16 | transmission electron microscope |
| 17 | electron source |
| 18 | electrode |
| 19 | electrode |
| 20 | electrode |
| 21 | magnetic lens (condensor) |
| 22 | magnetic lens (condensor) |
| 23 | magnetic lens (condensor) |
| 24 | objective lens |
| 25 | reference object |
| 26 | grid |
| 27 | controlling device |
| 28 | memory unit |
| 29 | microprocessor |
| 30 | means for measurement |
| 31 | tilt axis |
| 32 | display |
| 33 | motor control |
| 34 | motor |
| 35 | motor |
| 36 | position feedback |
| 37 | frame grabber and display |
| 38 | computer |
| 39 | coordinate display and entry |
| 40 | optical defect classification system |
| 41 | holding element mapping unit |
| 42 | joystick |

**Claims**

1. Method for controlling and monitoring a position of a holding element (11), wherein said holding element (11) is provided to hold a sample (12) to be examined and wherein said holding element (11) is part of a device (1, 16), said holding element (11) taking a current physical position $(X_p, Y_p)$ in a first coordinate system when it is in a corresponding position $(X_u, Y_u)$ in a second coordinate system,
said method comprising the steps of:

   - providing at least one first position $(X_0, Y_0)$ in said second coordinate system as a reference point, said first position $(X_0, Y_0)$ is provided by a reference object (12, 25, 26), said holding element (11) taking a first physical position $(X_A, Y_A)$ in said first coordinate system in said first position $(X_0, Y_0)$;
   - providing at least one error map by means of said at least one first position $(X_0, Y_0)$, said error map comprising a deviation (eX, eY) of at least one second physical position of said holding element (11) in said first coordinate system from a corresponding position of said holding element (11) in said second coordinate system;
   - providing at least one correction map by means of said error map, wherein said correction map comprises a deviation ($eX$, $eY$ $eX_D$, $eY_D$) of at least one third physical position of said holding element (11) in said first coordinate system from a corresponding position of said holding element (11) in said second coordinate system, and wherein said correction map provides a non-linear coordinate translation between said first coordinate system and said second coordinate system;

wherein said method further comprises at least one of the steps:

- moving said holding element (11) to said third physical position ($X_D + eX_D$, $Y_D + eY_D$) in said first coordinate system corresponding to said corresponding position as a desired position ($X_D$, $Y_D$) in said second coordinate system according to said correction map; and
- reporting said corresponding position in said second coordinate system corresponding to said third physical position in said first coordinate system by means of said correction map.

**2.** Method according to claim 1, wherein said method further comprises the step of storing said error map and/or correction map.

**3.** Method according to claim 1 or 2, wherein said step of providing an error map comprises taking into account an initial rotation (R) of said reference object (12, 25, 26).

**4.** Method according to one of the preceding claims, wherein said step of providing an error map comprises correcting a tilt of the reference object (12, 25, 26).

**5.** Method according to one of the preceding claims, wherein said reference object (12, 25, 26) is provided by a reference grid (26) having at least one vertex being said first position ($X_0$, $Y_0$).

**6.** Method according to one of the preceding claims, wherein said deviation ($eX$, $eY$) is measured visually.

**7.** Method according to one of the preceding claims, wherein said deviation ($eX$, $eY$) is calculated by an iterative process.

**8.** Method according to one of the preceding claims, wherein said reference object is provided by said sample (12) to be examined.

**9.** Method according to one of the preceding claims, wherein said step of providing said error map comprises determining of said deviation ($eX$, $eY$) of said at least one second physical position ($X_p$, $Y_p$) of said holding element (11) in said first coordinate system from said corresponding position ($X_u$, $Y_u$) of said holding element (11) in said second coordinate system by means of interpolation.

**10.** Method according to claim 9, wherein said interpolation comprises the method of Delaunay Triangulation.

**11.** Method according to claim 9, wherein said interpolation comprises the method of inverse distance weighting.

**12.** Method according to one of the preceding claims, wherein said step of providing said correction map comprises determining of said deviation ($eX$, $eX$) of said third physical position ($X_p$, $Y_p$) of said holding element (11) in said first coordinate system from said corresponding position ($X_u$, $Y_u$) of said holding element (11) in said second coordinate system by means of interpolation.

**13.** Method according to claim 12, wherein said interpolation comprises polynomial interpolation.

**14.** Method according to claim 12 or 13, wherein said interpolation comprises interpolation functions based on bilinear, biquadratic, bicubic and/or cubic splines and/or Delaunay Triangulation.

**15.** Method according to one of the preceding claims, wherein said method further comprises the steps of:

- entering a desired position ($X_p$, $Y_p$) of said holding element (11) in an input device (26, 38).

**16.** Method according to one of the preceding claims, wherein said step of reporting comprises the step of calculating said position ($X_u$, $Y_u$) in said second coordinate system by an iterative process.

17. Method according to one of the preceding claims, wherein said step of providing said correction map comprises the step of providing said correction map for said holding element (11) being tilted around an axis (31).

18. Method according to one of the preceding claims, wherein said step of providing said error map further comprises the step of correcting errors due to temperature influences.

19. Method according to one of the preceding claims, wherein a light overlay reference sample (26) is used as said reference object.

20. Method according to one of the preceding claims, wherein providing said at least one first position $(X_0, Y_0)$ comprises

   - providing several first positions $(X_0, Y_0)$, and
   - providing said error map as well as said correction map for each of said several first positions $(X_0, Y_0)$.

21. Method according to one of the preceding claims, wherein the method further comprises

   - providing a plurality of sample loads,
   - providing said error map and said correction map for each of said sample loads, and
   - using one error map of said error maps and/or one correction map of said corrections maps for said moving of said holding element and/or for said reporting.

22. Device (1, 16) for controlling and monitoring a position of a holding element (11), wherein said holding element (11) is provided to hold a sample (12) to be examined, said device (1, 16) being capable of carrying out in particular a method according to one of the preceding claims,
   wherein said holding element (11) is part of said device (1, 16) and takes a current physical position $(X_p, Y_p)$ in a first coordinate system when it is in a corresponding position $(X_u, Y_u)$ in a second coordinate system, said device comprising

   - a means for providing at least one first position $(X_0, Y_0)$ in said second coordinate system as a reference point, said first position $(X_0, Y_0)$ is provided by a reference object (12, 25, 26), said holding element (11) taking a first physical position $(X_A, Y_A)$ in said first coordinate system in said first position $(X_0, Y_0)$;
   - a means for providing at least one error map by means of said at least one first position $(X_0, Y_0)$, said error map comprising a deviation (eX, eY) of at least one second physical position of said holding element (11) in said first coordinate system from a corresponding position of said holding element (11) in said second coordinate system;
   - a means for providing at least one correction map by means of said error map, wherein said correction map comprises a deviation (eX, eX, $eX_D$, $eY_D$) of at least one third physical position of said holding element (11) in said first coordinate system from a corresponding position $(X_D, Y_D)$ of said holding element (11) in said second coordinate system, and wherein said correction map provides a non-linear coordinate translation between said first coordinate system and said second coordinate system;
   - a means for moving said holding element (11) to said third physical position $(X_p, Y_p)$ in said first coordinate system corresponding to said corresponding position as a desired position $(X_D, Y_D)$ in said second coordinate system according to said correction map; and
   - a means for reporting said corresponding position in said second coordinate system corresponding to said third physical position in said first coordinate system by means of said correction map.

23. Device (1, 16) according to claim 22, wherein said device (1, 16) comprises at least one storing unit (28, 41).

24. Device (1, 16) according to claim 22 or 23, wherein said device (1, 16) comprises at least one microprocessor (29, 38).

25. Device (1, 16) according to one of the claims 22 to 24, wherein said reference object (12, 25, 26) is designed as a reference grid (26) having at least one vertex being said first position $(X_0, Y_0)$.

26. Device (1, 16) according to one of the claims 22 to 25, wherein said reference object is designed as said sample (12) to be examined.

27. Device (1, 16) according to one of the claims 22 to 26, wherein said device (1, 16) comprises a means (29, 38) for determining of said deviation (eX, eY) of said second physical position $(X_p, Y_p)$ of said holding element (11) in said first coordinate system from said corresponding position $(X_u,Y_u)$ of said holding element (11) in said second coordinate system by means of interpolation.

28. Device (1, 16) according to one of the claims 22 to 27, wherein said device (1, 16) comprises a means for determining of said deviation of said third physical position $(X_p,Y_p)$ of said holding element (11) in said first coordinate system from said corresponding position $(X_u, Y_u)$ of said holding element (11) in said second coordinate system by means of interpolation.

29. Device (1, 16) according to one of the claims 22 to 28, wherein said device (1, 16) comprises an input device (26) and an output device (38).

30. Beam device (1, 16), in particular a particle beam device, comprising:

   - a beam generator (2, 17) that generates a beam;
   - an objective lens (8, 24) that focuses the beam on an object (12) being held by a holding element (11); and
   - a device (27, 38) for controlling and monitoring a position of said holding element (11) according to one of the claims 22 to 29.

31. Beam device (1, 16) according to claim 30, wherein said beam device (1, 16) is an electron beam device.

32. Beam device (1, 16) according to claim 31, wherein said beam device (1) is a scanning electron microscope.

33. Beam device according to claim 31, wherein said beam device (16) is a transmission electron microscope.

34. Recordable medium (31) comprising an executable code, wherein said executable code comprises a method according to one of the claims 1 to 21.

Fig. 1

Fig. 2

Fig. 3

EP 2 003 526 A1

Fig. 4

Take reference object
with grid
or sample with grid — S1

Determining grid spacing — S2

Determining $X_o$ / $Y_o$ — S3

Set M = 0
N = 0 — S4

Determining rotation, tilt
temperature influence — S5

Determining next theoretical
grid point $X_T$ / $Y_T$ — S6

Determining deviation $eX, eY$ — S7
theoretical grid point / actual grid point

Storing deviation $eX, eY$, — S8
theoretical grid point $X_T, Y_T$
actual grid point $X_A, Y_A$

Again — S9

Yes

Set
N := N + 1 — S10
M := M + 1

No

S21

Interpolation
of further grid points ~ S21

Interpolation of eX, eY
of further grid points ~ S22

Storing of further grid
points with corresponding
eX, eY ~ S23

Fig. 5

26

eX, eY

x

y

Fig. 6

26

25/13

Fig. 7a

$P_1$  $P_2$

Fig. 7b

25/12

Entering desired position $X_D/Y_D$ — S24

Taking grid with determined $eX/eY$ — S25

Interpolation of $eX_D/eY_D$ at $X_D/Y_D$ — S26

Storing — S26A

Moving holding element to $X_D + eX_D / Y_D + eY_D$ — S27

Fig. 8

Determining of actual position of holding element $X_p / Y_p$ — S28

Iterative Process based on Eq. 7 and Eq. 8 to search for $X_u / Y_u$ — S29

Storing — S29A

Showing position $X_u / Y_u$ — S30

Fig. 9

Providing error map at different tilt angle $\alpha_1$; $\alpha_2$; $\alpha_3$ ⸝— S100

Determining of angle β of holding element ⸝~ S200

Providing correction map at angle β by interpolation ⸝ S300

Fig. 10

## EUROPEAN SEARCH REPORT

**European Patent Office**

| Application Number |
|---|
| EP 07 01 1573 |

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 302 830 A (MITSUBISHI ELECTRIC CORP [JP]) 16 April 2003 (2003-04-16) * abstract * * paragraphs [0019] - [0025] * * paragraphs [0029], [0030] * * paragraphs [0042] - [0085] * * figures 2,6-8,12 * | 1-34 | INV. G05B19/404 H01J37/00 |
| X,D | US 6 864 488 B2 (MURAKI MASATO [JP]) 8 March 2005 (2005-03-08) * figures 1,5 * * column 3, line 44 - column 4, line 44 * * column 10, line 53 - column 12, line 61 * | 1-34 | |
| X,D | US 3 555 254 A (GERBER HEINZ JOSEPH) 12 January 1971 (1971-01-12) * the whole document * | 1-34 | |
| X | EP 0 353 585 A (SIEMENS AG [DE]) 7 February 1990 (1990-02-07) * column 1, lines 1-12 * * column 2, line 4 - column 4, line 25 * | 1,20-22, 34 | TECHNICAL FIELDS SEARCHED (IPC) |
| X | DE 101 55 430 A1 (SIEMENS AG [DE]) 28 May 2003 (2003-05-28) * abstract * * paragraphs [0001] - [0008] * * paragraphs [0012] - [0015] * * paragraphs [0028] - [0034] * | 1,7,16, 22 | G05B H01J |
| A | US 4 354 404 A (RAMUSINO FRANCESCO C) 19 October 1982 (1982-10-19) * claim 5 * | 1,22 | |
| A | US 4 885 449 A (SUZUKI TOSHIO [JP] ET AL) 5 December 1989 (1989-12-05) | 1-34 | |

The present search report has been drawn up for all claims

| Place of search | Date of completion of the search | Examiner |
|---|---|---|
| Munich | 10 October 2007 | Schriefl, Josef |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 01 1573

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2007

| Patent document cited in search report | | Publication date | Patent family member(s) | | Publication date |
|---|---|---|---|---|---|
| EP 1302830 | A | 16-04-2003 | WO 02091096 A1 | | 14-11-2002 |
| | | | US 2003184252 A1 | | 02-10-2003 |
| US 6864488 | B2 | 08-03-2005 | US 2003107006 A1 | | 12-06-2003 |
| US 3555254 | A | 12-01-1971 | DE 1638032 A1 | | 23-12-1971 |
| | | | GB 1142774 A | | 12-02-1969 |
| EP 0353585 | A | 07-02-1990 | NONE | | |
| DE 10155430 | A1 | 28-05-2003 | US 2003144809 A1 | | 31-07-2003 |
| US 4354404 | A | 19-10-1982 | DE 3009393 A1 | | 16-10-1980 |
| | | | IT 1165014 B | | 22-04-1987 |
| US 4885449 | A | 05-12-1989 | CH 673001 A5 | | 31-01-1990 |
| | | | DE 3790662 C2 | | 24-01-1991 |
| | | | WO 8803074 A1 | | 05-05-1988 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3555254 A
- US 20050211929 A1
- US 6864488 B2

**Non-patent literature cited in the description**

- **C.G. BROYDEN.** *Mathematics of Computation,* 1965, vol. 19, 557-593
- Numerical Recipes. C, Cambridge University Press, 1992